# EUROPÄISCHE PATENTANMELDUNG

(11) **EP 1 557 678 A1**
(43) Veröffentlichungstag der Anmeldung: **27.07.2005**
(21) Anmeldenummer: 04030809.0
(22) Anmeldetag: 27.12.2004
(51) Int. Cl.: G01R 11/24, G01R 21/00, G09F 3/03, F16B 41/00, H05K 5/02

(54) **Stromzähleranordnung**

(30) Priorität: 20.01.2004 DE 202004000858 U
(71) Anmelder: ABB PATENT GmbH, 68526 Ladenburg (DE)
(72) Erfinder: Vogel, Albrecht, Dr.-Ing., 76297 Stutensee (DE); Fritsch, Klaus, Dipl.-Ing., 67126 Hochdorf-Assenheim (DE)
(74) Vertreter: Miller, Toivo

(57) **Zusammenfassung**

Die Erfindung betrifft eine Stromzähleranordnung (10) mit einem Stromzähler (12) und einem Adapter (11) und mit einer Plombiereinrichtung, mit der das unbefugte Entfernen des Stromzählers (12) vom Adapter (11) behindert ist. Die Plombiereinrichtung weist eine Plombierstange (19) auf, deren freies Ende einen Gewindeabschnitt aufweist, der in einen am Adapter (11) angebrachten Innengewindeabschnitt (34) einschraubbar ist.

## Beschreibung

Die Erfindung betrifft eine Stromzähleranordnung gemäß dem Oberbegriff des Anspruches 1.

Bei einer derartigen Stromzähleranordnung, bei der der Stromzähler auf einem Adapter befestigt ist, der in einem Installationsverteilergehäuse untergebracht ist, sind vom EVU herkommende Stromzuführungsleitungen mit den Eingangsanschlüssen des Stromzählers verbunden, wogegen die Ausgangsanschlüsse des Stromzählers mit dem Verbrauchernetz in elektrisch leitender Verbindung stehen.

Zur Vermeidung von Stromdiebstahl ist es erforderlich, ein unbefugtes Entfernen des Stromzählers vom Adapter zu verhindern. Beispielsweise könnte eine solche Verriegelungseinrichtung so ausgebildet sein wie in der DE 103 44 736.9, Fig. 9 beschrieben, in der ein Verriegelungshebel mit einer Verriegelungsausnehmung und einer Plombieröffnung dargestellt sind.

Bei einer anderen Ausführungsform könnte als Plombierung eine Verriegelungsstange vorgesehen sein, die mit dem einen Ende in den Adapter eingeführt wird, wobei an dieser Verriegelungsstange eine Nase angeformt ist, die nach Verdrehen hinter die Abdeckplatte des Adapters schwenkbar ist; in dieser Lage kann die Plombierstange von vorne plombiert werden.

Aufgabe der Erfindung ist es, eine Stromzähleranordnung zu schaffen, bei der mit dem Plombiervorgang gleichzeitig auch der Stromzähler am Adapter verriegelt ist.

Diese Aufgabe wird erfindungsgemäß durch die Merkmale des Anspruches 1 gelöst.

Weitere vorteilhafte Ausgestaltungen der Erfindung sind den Unteransprüchen zu entnehmen.

Es zeigen
- Fig. 1: eine schematische perspektivische Darstellung einer Stromzähleranordnung,

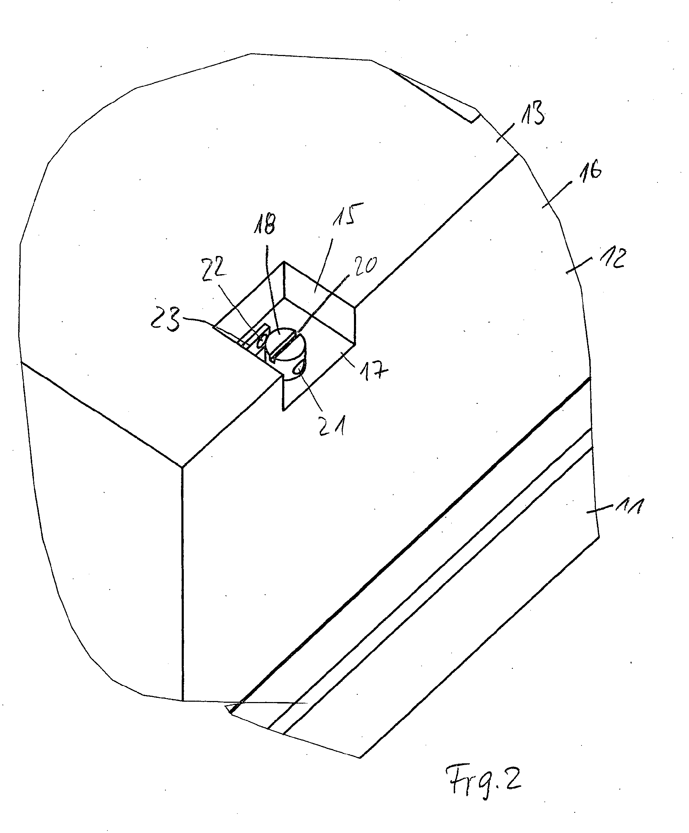

- Fig. 2: eine perspektivische Aufsicht auf den Stromzähler und
- Fig. 3: eine Teilschnittansicht von Stromzähler und Adapter.

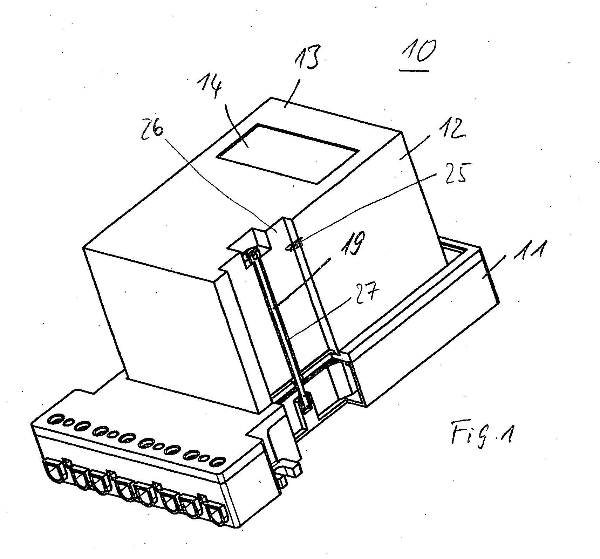

Eine Stromzähleranordnung 10 besitzt einen Adapter 11, der auf ein Zählerkreuz im Inneren einer Installationsverteilungsanordnung befestigt ist. Auf den Adapter 11 ist ein Stromzähler 12 aufgesetzt, der an seiner Frontseite 13, an der ein Anzeigefenster 14 vorgesehen ist, eine rechteckige Vertiefung 15 aufweist, die in eine senkrecht dazu verlaufende und senkrecht zu der Befestigungsfläche des Stromzählers 12 am Adapter 11 befindliche Seitenfläche 16 einmündet. Aus der Bodenfläche 17 der Vertiefung 15 ragt der Kopf 18 einer Plombierstange 19 (siehe Fig. 1) heraus, der an seiner Stirnfläche einen Schlitz 20 und darunter quer dazu eine Durchgangsbohrung 21 aufweist, durch die ein Plombierungsdraht (nicht dargestellt) hindurch gefädelt werden kann, wobei am Stromzähler 12 eine mit einer Durchgangsöffnung 22 versehene Lasche 23 vorgesehen ist; die Plombierung erfolgt dann dadurch, dass durch die Durchgangsbohrung 21 und die Öffnung 22 der Plombierdraht hindurch gesteckt werden kann. Der Schlitz 20 ist für den Eingriff eines Werkzeuges zum Verdrehen der Plombierstange 19 vorgesehen.

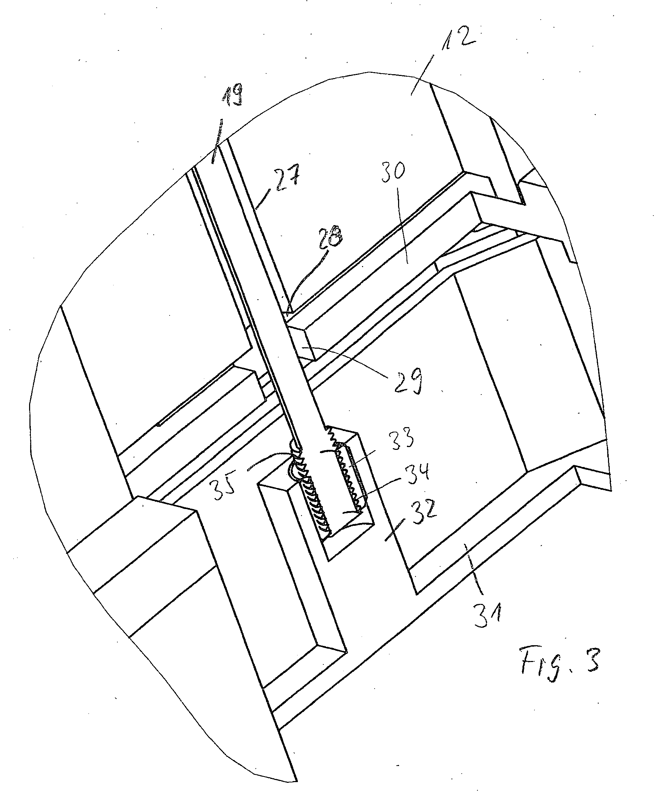

Die Fig. 1 zeigt einen Vertiefungsschnitt 25, wodurch eine fiktive Ebene 26 gebildet ist, die genau durch die Mittelachse der Plombierstange 19 hindurch verläuft und die zeigt, dass die Plombierstange 19 eine Durchgangsöffnung 27 im Stromzähler 12 durchgreift. Die Fig. 3 zeigt dies teilweise in vergrößerter Darstellung.

Die Plombierstange 19 durchgreift dabei auch einen Durchbruch 28 im Boden des Stromzählers 12 und eine Durchbrechung 29 in der dem Stromzähler 12 zugewandten Abdeckplatte 30 des Adapters. An der Bodenseite 31 des Adapters ist ein zum Stromzäher 12 hin vorspringender Pfosten 32 angeformt, in den eine Hülse 33 mit einem Innengewinde 34 eingepresst bzw. eingegossen ist. In das Innengewinde 34 wird dann ein Außengewinde 35 an dem dem Kopf 18 entgegengesetzten Ende der Plombierstange 19 eingeschraubt.

Mit dem Einschrauben der Plombierstange 19 in die Hülse 33, die aus Metall hergestellt sein kann, wird der Stromzähler 12 mit dem Adapter fest verbunden, so dass gleichzeitig mit der Plombierung auch die Verriegelung des Stromzählers 12 am Adapter erzielt ist.

Das Innengewinde kann natürlich auch in geeigneter Weise an der Abdeckplatte 30 fixiert sein.

## Patentansprüche

1. Stromzähleranordnung (10) mit einem Stromzähler (12) und einem Adapter (11) und mit einer Plombiereinrichtung, mit der das unbefugte Entfernen des Stromzählers (12) vom Adapter (11) behindert ist, **dadurch gekennzeichnet, dass** die Plombiereinrichtung eine Plombierstange (19) aufweist, deren freies Ende einen Gewindeabschnitt aufweist, der in einen am Adapter (11) angebrachten Innengewindeabschnitt (34) einschraubbar ist.

2. Stromzähleranordnung (10) nach Anspruch 1, **dadurch gekennzeichnet, dass** der Innengewindeabschnitt (34) in einer Hülse (33) eingebracht ist, die im Adapter (11) festgelegt ist.

3. Stromzähleranordnung (10) nach Anspruch 2, **dadurch gekennzeichnet, dass** die Hülse (33) am Adapterboden (31) fixiert ist.

4. Stromzähleranordnung (10) nach Anspruch 2, **dadurch gekennzeichnet, dass** die Hülse (33) im Adapteroberteil oder Adapterdeckel befestigt ist.
